Europäisches Patentamt

European Patent Office

Office européen des brevets

(19)

(11) **EP 1 043 817 A2**

(12) **EUROPEAN PATENT APPLICATION**

(43) Date of publication:
**11.10.2000 Bulletin 2000/41**

(51) Int Cl.7: **H01S 5/022**, H01S 5/026,
G02B 6/42

(21) Application number: **00303003.8**

(22) Date of filing: **10.04.2000**

(84) Designated Contracting States:
**AT BE CH CY DE DK ES FI FR GB GR IE IT LI LU
MC NL PT SE**
Designated Extension States:
**AL LT LV MK RO SI**

(30) Priority: **08.04.1999 JP 10126399**

(71) Applicant: **SUMITOMO ELECTRIC INDUSTRIES,
LTD.**
**Osaka-shi, Osaka (JP)**

(72) Inventor: **Hayashi, Hideki,**
**Sumitomo Electric Ind. Ltd.**
**Yokohama-shi, Kanagawa (JP)**

(74) Representative:
**Cross, Rupert Edward Blount et al**
**BOULT WADE TENNANT,**
**Verulam Gardens**
**70 Gray's Inn Road**
**London WC1X 8BT (GB)**

(54) **Light emitting module**

(57) A light emitting module is provided with an optical element having an optical waveguide with a predetermined refractive index, and a semiconductor optical amplifier for generating light in response to an electric current supplied thereto. The semiconductor optical amplifier has an optical emitting facet optically coupled with the optical waveguide, and an optical reflecting facet. The optical element includes the optical waveguide, a diffraction grating optically coupled with the optical waveguide, and electrodes and provided to apply an electric field to the diffraction grating. Light generated from the semiconductor optical amplifier is reflected by the diffraction grating. When an electric field is applied to the diffraction grating by the electrodes, the refractive index of the optical waveguide changes. In accordance with the change of the refractive index, the Bragg wavelength of the diffraction grating changes. As a result, the wavelength of the reflected light can be changed, so that the wavelength of light emitted from the light emitting module can be controlled.

Fig. 2

**Description**

BACKGROUND OF THE INVENTION

1. Field of the Invention

The present invention relates to a light emitting module in which a semiconductor optical amplifier, a planar optical waveguide and a planar optical modulator are combined with one another.

2. Description of the Related Art

In a 1.55μm-band wavelength division multiplexed (WDM) optical communication system, a plurality of signal lights which are different in wavelength from one another are transmitted through a single optical fiber in a lump. Here, the signal lights are referred to as channels respectively, and according to the ITU (International Telecommunications Union) standard, a wavelength interval between adjacent channels is defined to be 100 GHz (0.8 nm) or an integral multiple thereof. This requires that the channel wavelengths should be controlled with absolute accuracy of not less than four digits, that is, $1.55(\mu m) \div 0.8(nm) \fallingdotseq 2000$. In addition, according to the standard, it is necessary to transmit 16 or 32 channels of signals in a lump. Thus, the WDM system needs 16 or 32 light sources each having accuracy of not less than four digits.

As a semiconductor laser suitable therefor, a DFB (Distributed Feed Back) semiconductor laser, a DBR (Distributed Bragg Reflector) semiconductor laser may be used. In the DFB laser, a cladding layer above or under an active layer is processed geometrically, usually several hundreds nm, and semiconductor materials different in refractive index are buried therein, so that the diffraction grating is formed. In addition, in the DBR laser, this diffraction grating is formed in a position different from the active layer, and used as a wavelength-selective reflector. In these DFB and DBR semiconductor lasers, a sharp oscillation spectrum the half band width of which is not more than 10G is obtained. However, the oscillation wavelength is determined by the diffraction grating formed in the semiconductor materials in the laser manufacturing stage. Because of the influence of the uncontrollable condtion in the laser manufacturing process, it is not easy to obtain a period of desired oscillation wavelength stationarily and accurately.

A light emitting module in which a light emitting element is combined with a grating fiber is known as a light source having a sharp oscillation spectrum. The grating fiber is an optical fiber in which a diffraction grating is formed in its core. In such a light emitting module, the oscillation wavelength is primarily determined by the Bragg wavelength of the diffraction grating formed in the grating fiber. The diffraction grating is formed by irradiating the core with ultraviolet rays, and the Bragg wavelength of the diffraction grating cannot be changed after the diffraction grating has been once manufactured. In order to change the oscillation wavelength of such a module, it is necessary to change the grating fiber per se to be combined. Thus, the selecting the grating fiber has been required for applications, for example, to the WDM communication system, which requires oscillation wavelength with absolute accuracy of not less than four digits.

SUMMARY OF THE INVENTION

It is an object of the present invention to provide a light emitting module which can be controlled so as to emit light with a desired wavelength.

The method for emitting light with a predetermined oscillation wavelength can be roughly classified into the following two. (1) To manufacture a light source for emitting light with a predetermined oscillation wavelength, with high accuracy. (2) To manufacture a light source which can be changed in oscillation wavelength, and control the oscillation wavelength in accordance with the application.

This application relates to the approach (2). The oscillation wavelength is adjusted by changing the Bragg wavelength of a diffraction grating which determines the oscillation wavelength.

The light emitting module according to the present invention is provided with an optical element and a semiconductor optical amplifier. The semiconductor optical amplifier has an active layer for converting injection carrier into light. When an electric current is injected, the active layer generates light having a predetermined spectral band. The active layer has an optical emitting facet and an optical reflecting facet at its opposite ends. The optical emitting facet is optically coupled with a planar optical waveguide. The optical element includes the planar optical waveguide, a diffraction grating, and electrodes. The planar optical waveguide has a predetermined refractive index, and is surrounded by a medium having a refractive index smaller than the predetermined refractive index. The diffraction grating is formed in the planar optical waveguide, and has a predetermined reflection spectrum. The diffraction grating is a buried or refractive index modulated diffraction grating having a spatial periodical change of a refractive index. As the diffraction grating, a relief (or blade) one or a metal film equipped one having a periodical geometric shape may be adopted. The electrodes are provided so as to apply a voltage to a portion of the optical waveguide where the diffraction grating is formed.

The diffraction grating constitutes one reflector mirror of an optical resonator, and light generated by the semiconductor optical amplifier is reflected by the diffraction grating. When an electric field is applied to the diffraction grating, the refractive index of the optical waveguide changes. The Bragg wavelength of the diffraction grating changes in accordance with the change of the refractive index. Thus, the wavelength of the light to be reflected can be changed.

The light emitting module according to the present invention may be further provided with an optical modulator for modulating light generated by the semiconductor optical amplifier, in accordance with an electric signal. The optical modulator is preferably provided outside the optical resonator. If the optical modulator is provided outside the optical resonator, chirping of the emission spectrum can be reduced.

In the light emitting module according to the present invention, the optical element has a substrate provided with the optical waveguide, the diffraction grating and the electrodes. The substrate has an electro-optic material at least on its surface. This electro-optic material has an area having a predetermined refractive index as the optical waveguide, and an area surrounding the optical-waveguide area and having a refractive index smaller than the predetermined refractive index. The diffraction grating is provided in the optical waveguide so as to diffract light propagated through the optical waveguide. The electrodes are provided on the opposite sides of the optical waveguide so as to induce an electric field in the optical waveguide. When the electric field is induced, the refractive index of the optical waveguide changes due to the electro-optic effect, so that the Bragg wavelength of the diffraction grating changes.

BRIEF DESCRIPTION OF THE DRAWINGS

In the accompanying drawings:

Fig. 1 is a perspective view of a light emitting module, the view being partially broken to make the state of its inside apparent;
Fig. 2 is a sectional view taken on line I-I in Fig. 1, showing a main portion of the light emitting module;
Fig. 3 is a perspective view of a semiconductor optical amplifier;
Fig. 4 is a perspective view of an optical element having a diffraction grating;
Figs. 5A and 5B) are perspective views of optical elements each having a diffraction grating and an optical modulator on one and the same substrate; and
Figs. 6A to 6C are schematic views showing optical coupling arrangements in light emitting modules.

PREFERRED EMBODIMENTS OF THE INVENTION

Preferred embodiments of the present invention will be described with reference to the drawings.

First Embodiment

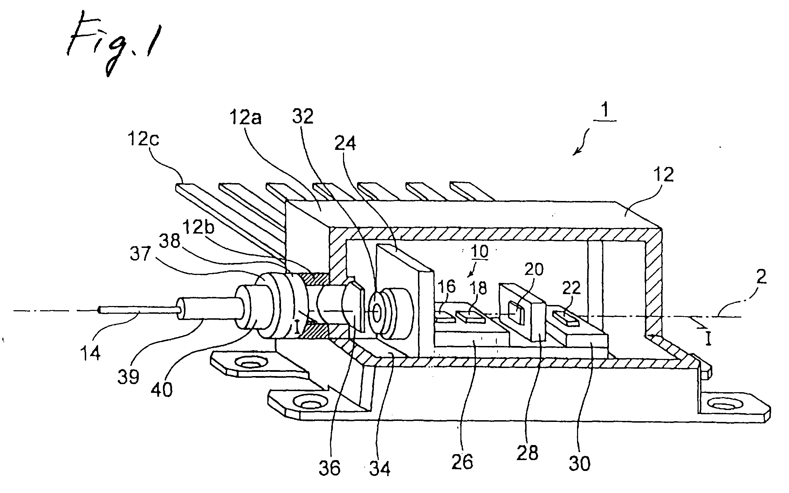

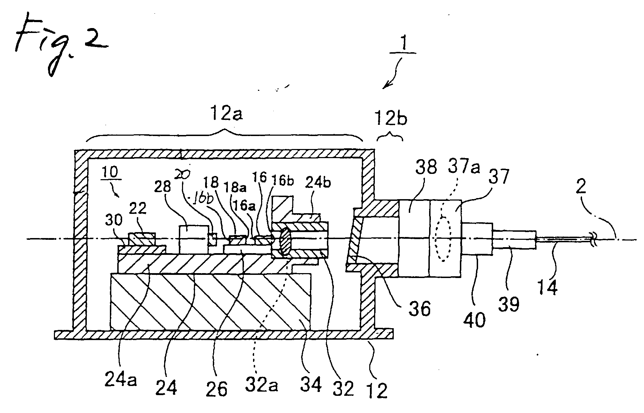

Description will be made about a light emitting module according to an embodiment of the present invention with reference to Figs. 1 and 2. Fig. 1 is a perspective view of a light emitting module. The view is partially broken to make the state of its inside apparent. Fig. 2 is a sectional view showing a main portion of the light emitting module. A light emitting module 1 has a device assembly unit 10 and a housing 12.

The housing 12 is a so-called butterfly package in the embodiment shown in Fig. 1. The device assembly unit 10 is disposed in the package 12 on its bottom surface. The device assembly unit 10 is sealed in the package 12 in the state where inert gas, for example, nitrogen gas, is charged into the package 12. The housing 12 has a body portion 12a receiving the semiconductor laser device assembly unit 10, a cylindrical portion 12b for guiding an optical fiber 14 into the device assembly unit 10, and a plurality of lead terminals 12c.

The device assembly unit 10 has a support member 24, chip carriers 26, 28 and 30, and a first lens holder 32 for holding a lens (32a of Fig. 2).

A semiconductor optical amplifier 16 and an optical element 18 are mounted on the chip carrier 26; a semiconductor light receiving device 20, on the chip carrier 28; and an electric signal processing device 22, on the chip carrier 30. The chip carriers 26, 28 and 30 are mounted on the support member 24. In addition thereto, the first lens holder 32 is also supported on the support member 24. The support member 24 is disposed on a thermoelectric cooler 34. The thermoelectric cooler 34 may be, for example, a temperature control element using a Peltier effect. The thermoelectric cooler 34 can control the temperature of the semiconductor optical amplifier through the support member 24. It is therefore preferable that the material of the support member 24 is a good heat conductor such as aluminum nitride (AlN) or the like.

In the inner wall of the body portion 12a, an optical window sealed with hermetic glass 36 is formed in a portion communicating with the cylindrical portion 12b. This window transmits light which propagates from the semiconductor optical amplifier 16 toward a tip portion (not shown) of the optical fiber 14. A second lens holder 37 for holding a lens (37a in Fig. 2) is attached to a forward end portion of the cylindrical portion 12b. An optical isolator 38 may be provided between the second lens holder 37 and the cylindrical portion 12b. The optical isolator 38 blocks light incident oppositely from the optical fiber 14 toward the semiconductor optical amplifier 16. The optical fiber 14 is covered at its forward end portion with a ferrule 39 so as to be protected. The second lens holder 37 holds a sleeve 40. The ferrule 39 is mated with the sleeve 40. When the ferrule 39 is inserted into the sleeve 40, the ferrule 39 is positioned optically relatively to the package 12. That is, the optical fiber 14, the lens 37a provided in the second lens holder 37, and the device assembly unit 10 are positioned so that the optical fiber 14 is optically coupled with the semiconductor optical amplifier 16.

With reference to Fig. 2, the support member 24 includes a device support portion 24a and a lens support portion 24b. The lens support portion 24b is provided on a main surface of the device support portion 24a so that the main surface of the device support portion 24a is at right angles to the main surface of the lens support portion 24b. The lens support portion 24b has a guide hole for receiving the first lens holder 32. The first lens holder 32 holds the lens 32a for collecting light from the semiconductor optical amplifier 16 mounted on the device support portion 24a. By moving the position of the first lens holder 32 along the optical axis of the lens 32a in the guide hole, the distance between the semiconductor optical amplifier 16 and the lens 32a can be controlled so that the optical coupling efficiency of both the members can be changed.

The semiconductor optical amplifier 16 is mounted on the chip carrier 26. The semiconductor optical amplifier 16 has an optical emitting facet 16a and an optical reflecting facet 16b which constitutes an optical resonator. The reflectivity of the optical emitting facet 16a is small enough (typically 1% or less) to make it possible to extract laser oscillation light from the optical emitting facet 16a. Since the value of the reflectivity of the optical emitting facet 16a is sufficiently small, the semiconductor optical amplifier 16 itself does not form a resonator, and cannot oscillate a laser. The optical emitting facet 16a is optically coupled with the optical fiber 14 through the lenses 32a and 37a.

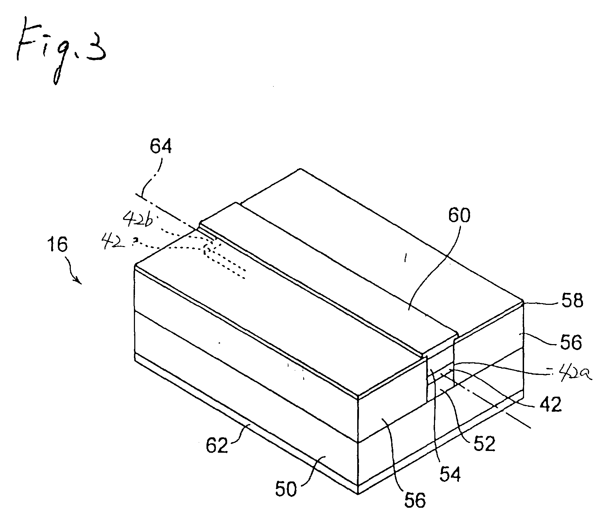

Fig. 3 is a view showing the configuration of the semiconductor optical amplifier 16. The semiconductor optical amplifier 16 has an active layer 42 in which light is generated and amplified in response to the injection of a carrier. The active layer 42 has the optical emitting facet 46a and the optical reflecting facet 46b on its opposite end portions respectively. The active layer 42 extends along a predetermined axis 64. The optical emitting facet 42a is preferably provided with an optical reflection reducing film for reducing light reflection. For example, a dielectric film (SiN film) is provided as the optical reflection reducing film. By adjusting the thickness of the dielectric film, the reflectivity in a predetermined wavelength can be reduced to about $10^{-3}$. Further, by setting an angle $\theta$ between the predetermined axis 64 and the normal of the optical emitting facet 16a to be about 7° (preferably in the range of 5° to 15°) the reflectivity can be lowered to a smaller value of about $10^{-5}$. On the other hand, the optical reflecting facet 42b is preferably provided with an optical reflection film for enhancing the reflectivity. A multi-layer film of dielectric films (SiN films) and amorphous Si films (a-Si films) may be used as the optical reflection film. By adjusting the thickness of each of the films and the number of the layers, the reflectivity in a predetermined wavelength can be increased.

The active layer 42 of the semiconductor optical amplifier 16 has a laminated structure, for example, an InGaAsP/InP double hetero structure. This structure is similar to a double hetero structure of a Fabry-Perot semiconductor laser. An n-type InP cladding layer 52, an undoped InGaAsP active layer 42, and a p-type InP cladding layer 54 are provided on one main surface of an n-type InP semiconductor substrate 50. These respective layers 42, 52 and 54 are formed into a stripe mesa shape extending along a predetermined axis 2. The mesa-shaped portions 42, 52 and 54 are held from their opposite sides by current blocking layers 56. Each current blocking layer 56 has a characteristic of p-n junction oppositely biased to an injected current, and has a function of blocking a current flowing in the portion and confining all the injected current in the mesa-shaped stripe portions 42, 52 and 54. An insulating film 58 of $SiO_2$, SiN, or the like, is provided on the current blocking layers 56. The insulating film 58 has an opening portion correspondingly to the mesa stripe portions, and an electrode 60 for a p-type semiconductor is provided in the opening portion. In addition, an electrode 62 for an n-type semiconductor is provided on the back surface of the substrate 50. The p-type electrode 60 may be formed on a contact layer of $p^+$-InGaAs formed on the cladding layer 54 and the current blocking layers 56.

When such a structure is provided, the refractive index of the active layer 42 becomes larger than those of the cladding layers 52 and 54 and the current blocking layers 56. With this structure, light generated in the active layer 42 can be optically confined in the active layer 42. Then, the active layer 42 may have a laminated structure such as MQW (Multiple Quantum Well) adopted in a semiconductor laser or the like, in accordance with the wavelength of the generated light. In addition, a carrier confinement area and an optical confinement area may be separated from each other.

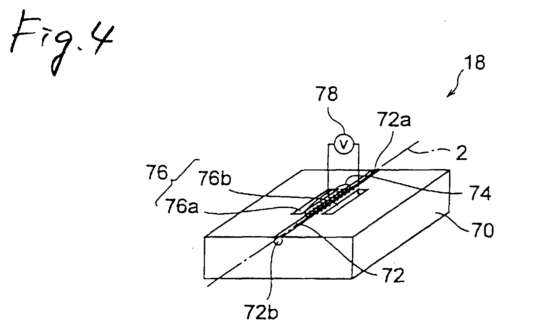

Fig. 4 is a view for explaining a schematic configuration of the optical element 18. The optical element 18 has a substrate 70 made of electro-optic material, an optical waveguide 72 provided on the substrate 70, a diffraction grating 74 formed in the optical waveguide 72, and a pair of electrodes 76 (76a and 76b). In the optical element 18, the optical waveguide 72, the diffraction grating 74 and the pair of electrodes 76 (76a and 76b) are provided on one main surface of the substrate 70 made of electro-optic material. The substrate 70 is preferably made of material such as $LiNbO_3$ or $LiTaO_3$ which has a large Pockels constant and in which it is easy to form a planar waveguide. The optical waveguide 72 has a first terminal portion 72a and a second terminal portion 72b, and is formed as an area different in refractive index from that of the substrate 70 made of electro-optic material. Such a change of the refractive index is attained, for example, by introducing Ti atoms into a portion in which the optical waveguide 72 should be formed. Similarly, the diffraction grating 74 is formed by changing the quantity of introduced Ti atoms periodically. By use of such spatial refractive index modulation, a refractive index modulated diffraction grating is obtained. Alternatively, the refractive index can be changed by irradiating the introduced Ti atoms with ultraviolet rays to thereby change the chemical state of the Ti atoms by the energy of the ultraviolet rays. Then, the periodicity of the refractive index change with intervals of several hundreds nm can be achieved by dividing the irradiating ultraviolet rays into two light beams, and making these light beams interfere with each other. When the diffraction grating 74 is of a relief diffraction grating, the diffraction grating 74 can be formed in such a manner that the surface of the substrate 70 is removed by etching while leaving a corrugated shape (serrated shape) to some extent for the wavegiude portion. If the diffraction grating 74 is of a metal film equipped diffraction grating, the diffraction grating 74 can be realized by forming a metal film several hundreds nm thick on the surface of the waveguide with a period of several hundreds nm. In the diffraction grating, periodical refractive index distribution can be formed in the waveguide by use of the fact that an area under the metal film is different in equivalent refractive index from the rest area. The pair of electrodes 76 (76a and 76b) are connected to a power supply 78 provided along the diffraction grating 74. In order to apply an electric field to the diffraction grating 74 effectively, the electrodes 76a and 76b may be formed so as to be superimposed on the diffraction grating 74 and the optical waveguide 72.

A refractive index change $\Delta n(E)$ when an electric field E is applied to the electro-optic material will be estimated. The refractive index change $\Delta n(E)$ is expressed by:

$$\Delta n(E) = n^3 \cdot \gamma \cdot \Gamma \cdot E/2$$
$$= n^3 \cdot \gamma \cdot \Gamma \cdot (V/d)/2 \qquad (1)$$

Here, n denotes a refractive index of the optical waveguide; $\gamma$, a Pockels constant of the electro-optic material; d, an effective distance between the electrodes 76a and 76b; and V, the applied voltage between the pair of electrodes 76a and 76b. $\Gamma$ denotes a correction factor, which can take a value in a range of from 0 to 1. $LiNbO_3$ is adopted as the electro-optic material, the refractive index 2.2 of $LiNbO_3$ is adopted as the refractive index n, and $3.0 \times 10^{-5}$ (mm/V) of the same is adopted as the Pockels constant $\gamma$. As a result, the refractive index change $\Delta n(E)$ can be estimated to be $1.6 \times 10^{-4}$ (V/d).

There is a relation:

$$\lambda_B = 2 \cdot n \cdot \Lambda$$

between Bragg diffraction wavelength $\lambda_B$ of the grating 74 and a period $\Lambda$ of the refractive index of the diffraction grating 74. Therefore, that the wavelength $\lambda_B$ is in the 1.55 $\mu$m band and the Bragg diffraction wavelength is then shifted by 1 nm is equivalent to that the refractive index n is shifted by 1/1550, that is, by 0.06%. The electric field intensity then becomes $0.06\%/1.6 \times 10^{-4} \fallingdotseq 3.75$(V/mm). When the distance between the electrodes is made to be 1 mm, the foregoing wavelength shift is accomplished under the voltage of several volts. Such a voltage is a practical value for a light emitting module.

Since the refractive index of the optical waveguide is electrically changed so as to change the Bragg diffraction wavelength of the grating 74, a change or fine control can be given to the oscillation wavelength even after completion of the light emitting module. In addition, when the electric field to be applied to the diffraction grating 74 is changed in accordance with a change of temperature, a light emitting module having a temperature-compensated oscillation frequency can be realized.

In order to realize such electronic control, the electric signal processing device 22 is an active device such as an integrated circuit. Alternatively, the electric signal processing device 22 may include passive devices such as resistors, capacitors, etc. The electric signal processing device 22 is received in one and the same package so that the light emitting module according to the present invention is miniaturized.

Second Embodiment

An optical modulator may be provided on a substrate made of electro-optic material provided with a diffraction grating.

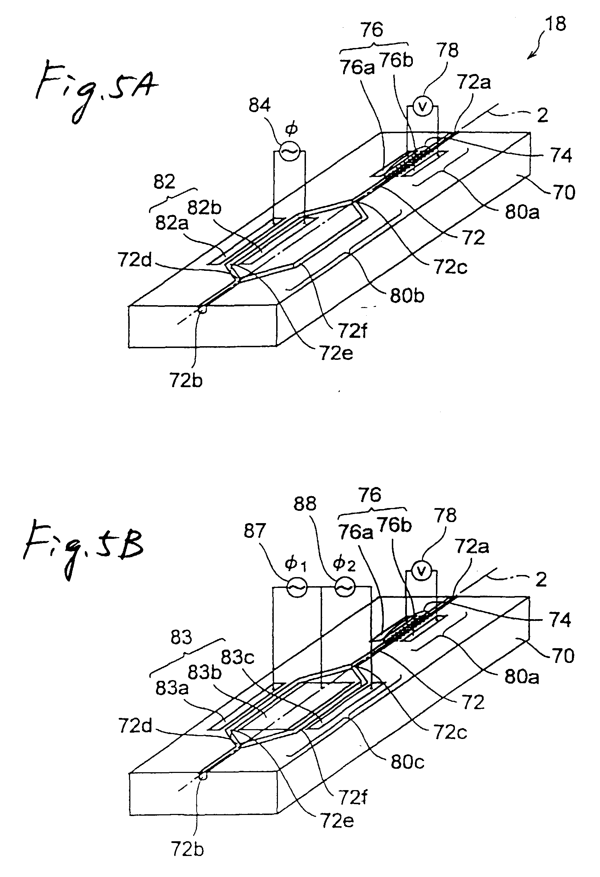

Fig. 5A is a view for explaining a planar optical modulator. Fig. 5A shows an optical element 18 having a diffraction grating portion 80a and an optical modulator 80b on a substrate 70 made of electro-optic material. The diffraction grating portion 80a has the same configuration as that in Fig. 4, and hence its description will be omitted. An optical waveguide 72 extends along a predetermined axis 2. The optical waveguide 72 has a first terminal portion 72a and a second terminal portion 72b. The optical waveguide 72 extending from the first terminal portion 72a passes through the diffraction grating portion 80a and reaches the optical modulator 80b. In the optical modulator 80b, the optical waveguide 72 branches into two branch waveguides 72e and 72f at an optical coupler 72c. Then, one branch waveguide 72e passes between a pair of electrodes 82 (82a and 82b). A modulating signal source $\phi$ 84 is connected between the pair of electrodes 82 (82a and 82b). After passing between the electrodes 82, the branch waveguide 72e meets the branch waveguide 72f at an optical coupler 72d, and reaches the second end surface 72b as a single optical waveguide 72. The optical couplers 72c and 72d have functions as optical branching and coupling portions.

A change of phase $\Delta\delta$ of light propagate in the wavelength 72e due to the voltage $\phi$ can be expressed by:

$$\Delta\delta = \pi \cdot 1 \cdot n^3 \cdot \gamma \cdot \Gamma \cdot (V/d)/\lambda \qquad (2)$$

The lengths of the electrodes 82a and 82b provided along the branch waveguide 72e are set to be 1. Here, n, $\gamma$, $\Gamma$, V, and d are similar to those for the expression (1), and $\pi$ denotes the ratio of the circumference of a circle to its diameter. In addition, a necessary applied voltage value of the modulating signal source 84 and the electrode length 1 can be defined by the expression. The modulation is performed by use of the fact that the lights passing through the branch waveguides 72e and 72f cancel each other in their combined light when the phase difference between those lights is 180°, and there occurs no loss due to the phase difference in the combined light when the phase difference is 0°.

Fig. 5B shows an optical element 18 having a diffraction grating portion 80a and an optical modulator 80c on a substrate 70 made of electro-optic material. The diffraction grating portion 80a has the same configuration as that in Fig. 4, and hence its description will be omitted. An optical waveguide 72 is formed along a predetermined axis 2. The optical waveguide 72 has a first terminal portion 72a and a second terminal portion 72b. The optical waveguide 72 extending from the first terminal portion 72a passes through the diffraction grating portion 80a and reaches the optical modulator 80c. In the optical modulator 80c, the optical waveguide 72 branches into two branch waveguides 72e and 72f at an optical coupler 72c. Then, one branch waveguide 72e passes between a pair of electrodes 83 (83a and 83b). A modulating signal source ($\phi$1) 87 is connected between the pair of electrodes 83a and 83b. The other branch waveguide 72f passes through a pair of electrodes 83b and 83c. A modulating signal source ($\phi$ 2) 88 is connected between the pair of electrodes 83b and 83c. After passing between the electrodes 83, the branch waveguides 72e and 72f are combined into a single optical waveguide 72 at an optical coupler 72d, and reach the second terminal portion 72b.

A change of phase $\Delta\delta$ between the two branch waveguides due to the voltages $\phi$1 and $\phi$2 can be estimated by the expression (2) in the same manner as in the foregoing case. Here, the lengths of the_respective electrodes 83a, 83b and 83c provided along the branch waveguides 72e and 72f are set to be 1 respectively. Applied voltage values of the modulating signal sources 87 and 88 and the electrode length l can be defined by the expression. In modulation, the voltages $\phi$1 and $\phi$2 are controlled so that the phase difference between lights which have passed through the branch waveguides 72e and 72f becomes 180°. The lights which have passed through the branch waveguides 72e and 72f cancel each other when they are combined at the optical coupler 72d if the phase difference between those lights is 180°, while those lights intensify each other when they are combined of the phase difference is 0°.

Electrodes are provided to hold at least one of at least two branch waveguides belonging to an optical waveguide. If a voltage is applied to the optical waveguide, the refractive index of the optical waveguide changes. The change of the refractive index changes the phase of light passing through the optical waveguide.

The signal sources for the optical modulators 80b and 80c shown in Figs. 5A and 5B are established entirely independently of the power supply for the semiconductor optical amplifier 16. Accordingly, the semiconductor optical amplifier 16 can be operated by direct current, and hence there occurs no chirping phenomenon due to an excess carrier in the active layer of the semiconductor optical amplifier.

Fig. 6A shows a typical relationship of optical coupling among the optical fiber 14, the semiconductor optical amplifier 16 and the optical element 18. The optical element 18, the semiconductor optical amplifier 16 and the optical fiber 14 are arranged along the optical axis 2 in this order. Fig. 6A schematicly shows the laser module described with reference to Figs. 1 and 2. The optical element 18 includes the diffraction grating 74. The optical emitting facet 16a of the semiconductor optical amplifier 16 is optically coupled with one end surface 72a of the optical waveguide 72. The optical reflecting facet 16b of the semiconductor optical amplifier 16 is optically coupled with tip portion 14a of the optical fiber 14. The tip portion 14a of the optical fiber 14 optically coupled with the optical reflecting facet 16b may have a lens shape portion the core portion of which is finished into a convex form. In addition, a collimator lens and a condenser lens may be provided between the optical emitting facet 16a of the semiconductor optical amplifier 16 and the tip portion 14a of the optical fiber 14. Light generated in the semiconductor optical amplifier is extracted through the optical fiber 14. In this example, the diffraction grating 74 of the optical element 18 and the optical reflecting facet 16b of the semiconductor optical amplifier 16 constitutes an optical resonator.

Fig. 6B shows a schematic relationship of optical coupling among the optical fiber 14, the semiconductor optical amplifier 16 and the optical element 18. The semiconductor optical amplifier 16, the optical element 18 and the optical fiber 14 are arranged along the optical axis 2 in this order. The optical element 18 includes the diffraction grating 74. The optical emitting facet 16a of the semiconductor optical amplifier 16 is optically coupled with one end surface 72a of the optical waveguide 72. Tip portion 14a of the optical fiber 14 is optically coupled with the optical waveguide 72 of the optical element 18 at the other waveguide terminal 72b. One terminal portion 14a of the optical fiber 14 is optically coupled with optical waveguide 72 of the optical element 18 at the waveguide end 72b. The terminal portion 14a of the optical fiber 14 optically coupled with the optical element 18 may have a lens shape portion the core portion of which is finished into a convex form. In addition, a condenser lens, or a combination of a collimator lens and a condenser lens may be provided between the waveguide terminal 72b of the optical element and the tip portion 14b of the optical fiber 14. The diffraction grating 74 of the optical element 18 and the optical reflecting facet 16b of the semiconductor optical amplifier 16 constitutes an optical resonator. Further, an optical isolator may be disposed between the optical element 18 and the optical fiber 14.

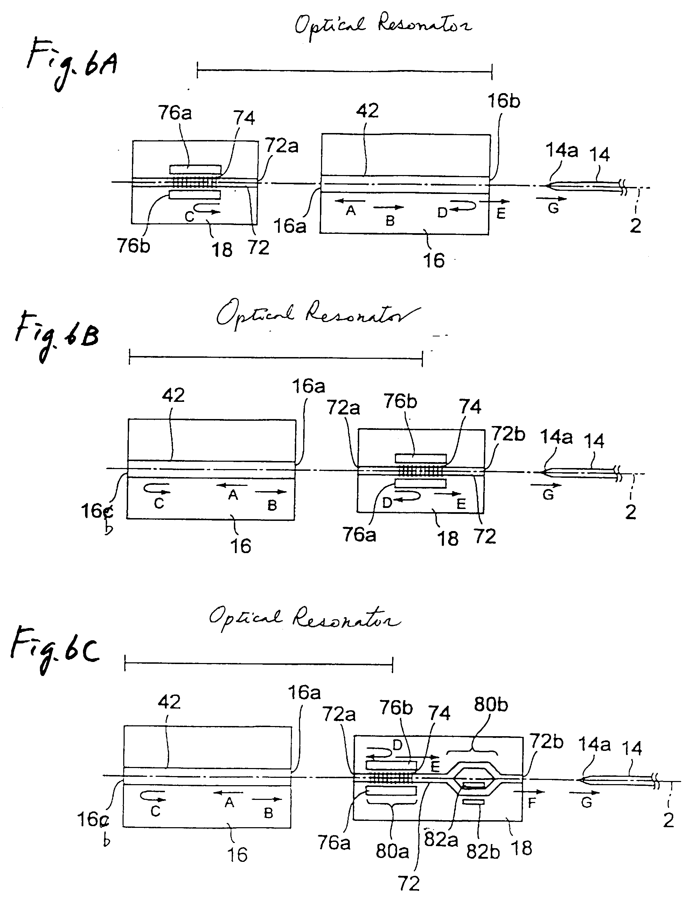

Fig. 6C shows a schematic relationship of optical coupling among the optical fiber 14, the semiconductor optical amplifier 16 and the optical element 18. The semiconductor optical amplifier 16, the optical element 18 and the optical fiber 14 are arranged along the optical axis 2 in this order. The optical element 18 includes the diffraction grating portion 80a and the optical modulator 80b. The optical emitting facet 16a of the semiconductor optical amplifier 16 is optically coupled with the optical waveguide 72 of the optical element 18 at the waveguide terminal 72a. Tip portion 14a of the optical fiber 14 is optically coupled with the optical waveguide 72 of the optical element 18 at the waveguide terminal 72b. The tip portion 14a of the optical fiber 14 optically coupled with the optical element 18 may have a lens shape portion the core portion of which is finished into a convex form. The diffraction grating 74 of the optical element 18 and the optical reflecting facet 16b of the semiconductor optical amplifier 16 constitutes an optical resonator. An optical isolator may be disposed between the optical element 18 and the optical fiber 14. The optical modulator 80b is disposed between the optical fiber 14 and the semiconductor optical amplifier 16, provided outside the optical resonator, and optically coupled with the optical resonator. Also when the optical modulator 80c is adopted, Fig. 6C is applicable with respect to the relationship of optical coupling in the same manner as in the foregoing case.

The operations of the light emitting modules shown in Figs. 6A to 6C will be described. In Figs. 6A to 6C, propagated lights A to G are drawn. The operation of the light emitting module shown in Fig. 6C will be described by way of example. This is because the operations of the light emitting modules shown in Figs. 6A and 6B are substantially the same as that of the light emitting module shown in Fig. 6C, except the description of the optical modulators.

When a carrier is injected into the semiconductor optical amplifier 16, lights A and B are generated. The light A is reflected on the light reflecting facet 16b, and then introduced into the optical element 18 through the light emitting facet 16a in the same manner as the light B. In the optical element 18, light D reflected on the diffraction grating 74 is introduced again into the semiconductor optical amplifier through the optical emitting facet 16a. This is repeated so that light is amplified. The diffraction grating 74 transmits a portion E of the light introduced thereto. The light E transmitted through the diffraction grating 74 is introduced into the optical modulator 80b. Light F modulated in the optical modulator 80b is output from the optical element 18. Light G introduced from the optical element 18 into the optical fiber 14 is propagated through the optical fiber 14.

Although there was shown a case where the optical element 18 had the diffraction grating 80a and the optical modulator 80b on the same substrate 70 made of electro-optic material, the diffraction grating 80a and the optical modulator 80b may be formed on different substrates.

As has been described in detail, the light emitting module according to the present invention has an optical element and a semiconductor optical amplifier. Light generated from the semiconductor optical amplifier is reflected by a diffraction grating. When an electric field is applied to the diffraction grating, the refractive index of an optical waveguide changes. In accordance with the change of the refractive index, the Bragg wavelength of the diffraction grating changes. As a result, the wavelength of the reflected light can be changed, so that the wavelength of light emitted from the light emitting module is made controllable.

Therefore, a light emitting module which is controllable to generate light with a desired wavelength is provided.

**Claims**

1. A light emitting module comprising:

    an optical element including an optical waveguide in which a diffraction grating is formed, and electrodes provided to apply a voltage to a portion of said light waveguide in which said diffraction grating is formed; and a semiconductor optical amplifier having an optical reflecting facet, and an optical emitting facet optically coupled with said optical waveguide.

2. A light emitting module according to claim 1, wherein said optical element further includes an optical modulator.

3. A light emitting module according to claim 2, wherein said optical reflecting facet of said semiconductor optical amplifier and said diffraction grating constitute an optical resonator, and said optical modulator is provided outside said optical resonator.

4. A light emitting module according to claim 2, wherein said optical element includes a planar optical waveguide and a planar optical modulator which are formed on a substrate made of electro-optic material.

5. A light emitting module according to claim 4, wherein said substrate made of electro-optic material is of LiNbO$_3$ or LiTaO$_3$.

6. A light emitting module according to claim 1, wherein said optical emitting facet is provided with an optical reflection reducing film for reducing reflection of light.

7. A light emitting module according to claim 1, wherein said optical reflecting facet is provided with an optical reflection film for enhancing the reflectivity.

Fig.1

Fig. 2

Fig.3

Fig.4

Fig.5A

Fig.5B

Fig. 6A

Optical Resonator

Fig. 6B

Optical Resonator

Fig. 6C

Optical Resonator